# EUROPEAN PATENT APPLICATION

(11) **EP 2 495 766 A1**
(43) Date of publication of application: **05.09.2012**
(21) Application number: 11154262.7
(22) Date of filing: 13.02.2011
(51) Int. Cl.: H01L 31/02

(54) **Safety system to reduce risk of electrocution at photovoltaic panels level**

(71) Applicant: Brucchi, Fabio, 00189 Roma (IT)
(72) Inventor: Brucchi, Fabio, 00189 Roma (IT)

(57) **Abstract**

Safety System to reduce risk of Electrocution at Photovoltaic Panels Level.

The present invention relates to an electronic system and related methods of control, to be used as safety switch at Photovoltaic Panels Level.

Said system can solve the dramatic issue of human exposition to electrocution in case of catastrophic event, like: fire, flooding, earthquakes, seaquakes... and also in case of installation or maintenance, without needs of further wiring and installation efforts.

Said System comprising: a main switch, 41, in parallel to the Photovoltaic Panel (PVP) and in parallel to the PVP by-pass diode(s), 48, a blocking element(s), 49, a DC/DC converter, 42, an Energy Storage Unit, 44, a Radio Frequency Activation System, 46, a control logic and driver circuitry, 47, a transmitter electronics, 51, located in a nearby area to the PVPs, which, once activated by means of manual intervention of an emergency button (i.e. during installations or maintenance) or by means of intervention of an electronic sensor board, 52, (because fire detection, flooding detection, earthquakes, etc...), transmits the signal information and the method of activation codes with related switches sequences to each PVP safety switch.

## Description

The present invention relates to an electronic system and related methods of controls, to be used as safety switch at Photovoltaic Panels Level.

There's a dramatic potential danger of electrocution for the humans caused by Photovoltaic Panels and Photovoltaic systems. Indeed, these systems and the related installations are rapidly expanding in modern cities and environments and the risk of electrocution at panel level it is not yet totally eliminated, even if all regulations and indications for a correct design and protection system are followed. Indeed, even when the Main DC switch of the High Voltage DC line is switched-off, it persists a considerable potential risk of accident during installations (e.g. during first installation or maintenance), and, even worse, in case of catastrophic event (such as: fire, flooding, earthquakes and seaquakes) or failure.

Present State-Of-The-Art protections at Photovoltaic Panels Level (thereinafter PVP) and methods of applications, are well know to installers and new solutions are also diffused. For example, there are several recommendations and suggestions to follow during installation: to cover with proper shits the PVPs, or to use special cover glasses or even to install the PVP during the night (with all the risk associated to work in a poorly lighted environment or with an energized environment). Instead, in case of catastrophic event, like: fire, flooding, earthquakes and seaquakes, there's virtually no protection for those who inadvertently touch the DC cables before the main switch, even in case of a proper Main DC switch opening. Especially fireman, policeman, Civil Protection operators and so forth... are very exposed to this kind of risk.

This is a serious shortcoming that this patent is intended to solve.

In the first case (during installations) there are now also available new intelligent and simple solutions, like the ones described in the patent US7807919B2 and also in the patent US20100253517, which are physical implementations of a mechanical separation of PVPs from the installations (even if in these patents, the systems can not be controlled remotely; in case of needs to control it remotely, it is necessary to trigger relays or semiconductors via external wiring and circuitries, while in the proposed solution there is no need of external installations, wires or circuitries).

In the second case, (i.e. in case of safety switch during catastrophic events), besides the trivial State-Of-The-Art solution to externally parallel to a PVP a simple relay connected by external wiring, there's, at present, no practical solution to create a controllable remote switch at panel level to be activated in case of failure, or a catastrophic event and to keep the PVP switched-off indefinitely (or for the whole duration of the event). Indeed, cables and wires can also be cut or damaged during a catastrophic event. Moreover, this patent could also allows to switch-on and switch-off with a single gesture (e.g. pushing an emergency button) all types of PV plants: from a single domestic PV-plant, up to huge Photovoltaic Power Stations, just in few seconds and under complete safety conditions at Panel Level.

According to the present invention, there is provided a system, consisting of electronic device(s) and/or electro-mechanical component(s), which is capable to keep under SELV (Safety Extra-Low Voltage) level, also for an indefinite period of time, PVP strings, PVP arrays or systems and to have, at its output terminals, a voltage level ― always and in any conditions - lower than SELV. Said system can be controlled through a Radio Frequency Activation Systems, or Wi-Fi, or Bluetooth or other wireless protected transmission systems able to assure communication even during a catastrophic event. Such a transmission system, can also be bi-directional in case of needs of feedbacks on the switches situation. Moreover, this system will avoid any further adding cost and installation efforts. The disclosure of this invention includes also the methods and the apparatuses to maintain the power supply of the electronic system, for indefinite period of time, also during PVP are in short-circuit conditions. Anyhow, in case of needs of physical wire connection, said system can be also simply controlled by external wiring.

In case of fire, the control electronics will shortly fail. In this case, in parallel to this electronic system, it is introduced an electro-mechanical switch for fire detection, which is capable to sustain indefinitely the PVP short-circuit current. Alternatively, said device may consists of a specific low temperature melting material (which could be a plastic, MMC or other material with a defined and stable low temperature melting point) sandwiched between two conductor elements (i.e. copper, aluminium or other electrical conductor elements) which keep the material in the middle under high pressure, till this reach the melting point. When the mid material starts to melt, the external conductors kept under pressure, shortly start to bend. After total fusion of the mid material, the two external conductors go in touch, creating a definitive short circuit (which can be removed only mechanically by operators).

Embodiments of the present invention with now be described, by way of example, with reference to the accompanying drawings, in which:
**Figures 1** shows a rear view of an existing State-Of-The-Art Photovoltaic Panel (PVP);
**Figure 2** shows a rear view of a PVP and an embodiment of the system described in the present patent, with a larger junction-box in which it is mounted said system;
**Figure 3** is a rear view of an existing PVP in which it has been added an embodiment of the system described in the present invention into a separated junction-box. Said added junction-box is connected, through standard PV cables, to a pre-existing junction-box;
**Figure 4** is a simplified schematic of the present invention related to a single Photovoltaic cell, unit or Panel and to the remote control activation system.
**Figure 5** is a block diagram of a PVP string in which, each PVP of the string has installed the system of the present invention;
**Figure 6** is a simplified block diagram of a PVP which has installed the system described in the present invention;
**Figures 7a, 7b, 7c and 7d** are simplified block diagrams of a PVP string. It is useful to explain the control method of the present invention, with activation of all switches excluding respectively: the 1^{st} PVP, the 2^{nd} PVP, the 3^{rd} PVP and the n^{th} PVP;
**Figure 8** is a block diagram of a PVP array in which, each PVP of the string has installed, on the rear of the Panel, the system of the present invention. Such a system has also an Over-Voltage protection for a non-contemporary intervention;
**Figure 9** is an embodiment of the electro-mechanical switch intended for fire protection and usually placed in parallel to the electronic safety switch described in the present invention.

For the purpose of illustration, this invention will be described, for simplicity, in a real application, with reference to only one PVP string unit, but obviously it is also applicable to other more complex structures, like PVP array, matrix or multi-array, etc....

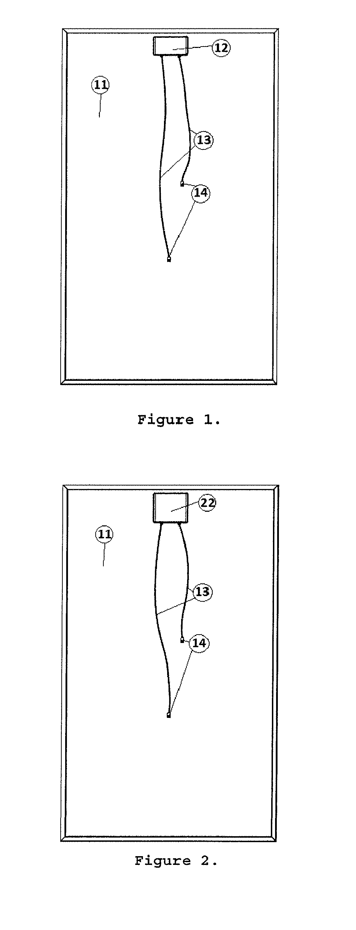

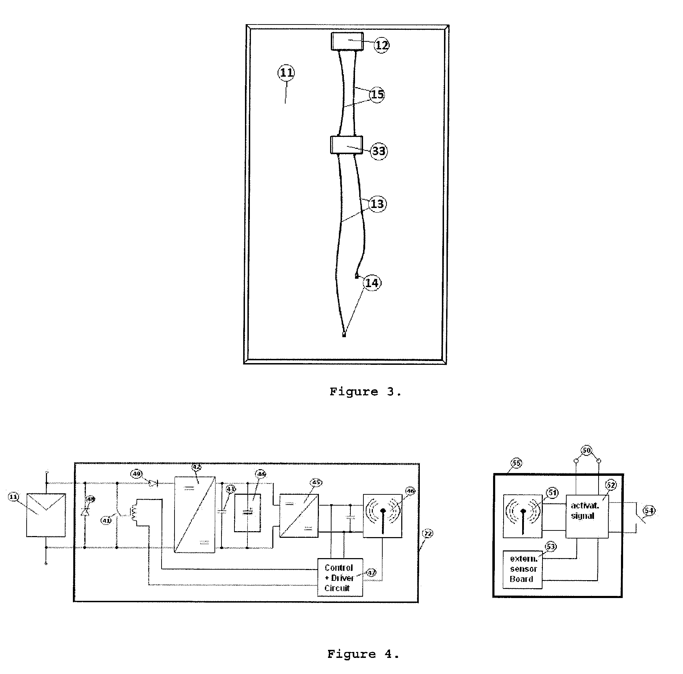

In the rear side of each PVP, 11, Fig. 1, of the string, it is added (mechanically fixed or also glued) a new junction-box, 33, Fig. 3. Said new junction-box, 33, is connected through pre-cabled wires, 15, Fig.3, having same standard PVP connectors type, 14; said added junction-box, 33, has same standard PVP cables and connectors, 13 and 14. In case of a new product, the PVP will have installed a larger junction-box, 22, Fig. 2, where is integrated the by-pass diode(s) and the electronic circuit of the present invention.

Inside said junction-box, 22, Figures 2 and 4, it is embedded an electronic circuit, as detailed in the simplified schematic shown in Fig. 4: in parallel of said PVP, 11, there is one (or more than one) Anti-parallel diode(s), 48. In parallel to this diode(s), in the same junction-box, 22, is placed the electronic safety switch of the present invention. It consists of a main switch, 41, which could be a Relay or, even better, a Semiconductor (MOSFET, BJT, VJFET, IGBT and the like). The series diode, 49, allows to keep charged the system connected to the cathode, even when the PVP voltage decreases or goes to zero volt. The DC/DC converter, 42, is necessary to keep stable the voltage across capacitor, 43, and to give specific charge profiles at constant current (said DC/DC converter is not always used) to the Energy Storage Unit, 44. The Energy Storage Unit, 44, in this application consists of an Electric Double Layer Capacitor (EDLC) capable to withstand to harsh environments and capable to complete million cycles of Charge/Discharge. This will definitely avoid the disadvantage of use of Electrochemical Batteries. (But, depending on the method of activation of the switches, on the type of switches, on the current consumption and on the activation sequence, said Energy Storage Unit may also consists of standard capacitors, such as tantalum, with large capacitance values). In this case, the main switch, 41, will be maintained in on-state for just few seconds, and then opened. The DC/DC converter, 45, converts the energy content of 44 into a right voltage level to supply the Radio Frequency (and/or Wi-Fi and/or Bluetooth) activation systems, 46. Through this system, it is received the input signal to keep the PVP shorted, during operation (installation or maintenance) or during catastrophic event or failure. A specific driver and control logic circuit, 47, will convert the signal to a correct voltage/current level to correctly drive the main switch (voltage level and sequence time depend on type of switch chosen, i.e. if semiconductor type or a relay).

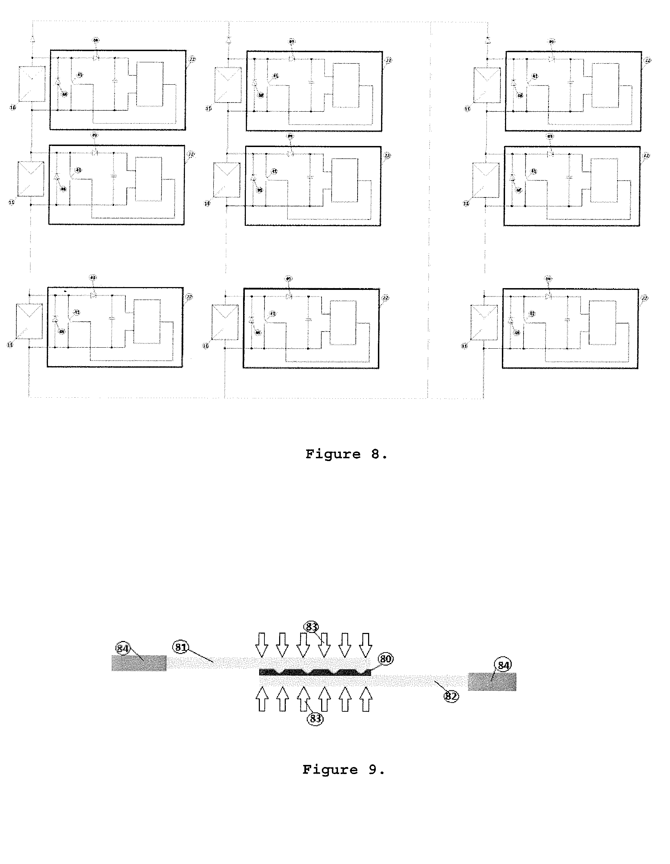

In parallel to this electronic system, it could be used an electromechanical device, Fig. 9, which assure intervention in case of fire. As previously described, the main function of this component is based on the melting point of the material, 80, Fig. 8, this material, 80, starts to melt, the external metal contacts, 81 and 82, put under considerable external pressure, 83 (which is typically applied by springs or by metal parts) starts to fold and go in touch, assuring a short-circuit of the external circuits/components connected at its terminations, 84, in case of fire, even when the external electronics totally fail because burnt. Such device can also consists of a standard fire detection switch, which must be capable to keep shorted and to sustain continuously the 8...9 ampere of the PVP short-circuit current.

The method of control of said electronic switches, is an important part of this patent, and it is the way which allow to feed the control circuitry resident onboard of the PVP, even when the PVP is kept shorted for long period of time and not using batteries, neither external cables/wires.

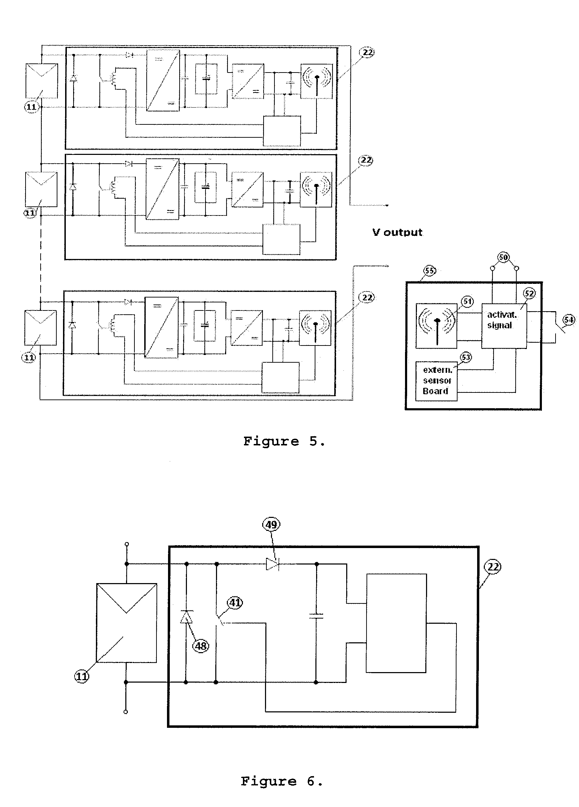

A series of PVPs (typically from 6 to 14 PVPs) shown in 11, Figures 1, 4 and 5, forms a string (as in Fig. 5). Each PVP of said string, has installed inside its junction-box (placed on the rear of the PVP), 22, Figures 2, 5 and 6, the electronic controllable switch described in the present invention.

The method of control, detailed by means of Figures: 7a, 7b, 7c and 7d, works as follow: as soon as the remote control, 55, Fig. 5, placed in a nearby location to the PVP string, starts the activation of the safety switch (by means of a safety button, 54, or by means of activation of external sensor board, 53). The controllable switches, placed in the rear side of each PVP, receive the activation signals and immediately start to close each PVP in short-circuit. In this condition, the output terminals of each PVP and, consequently, the main DC terminals stay at zero volt, even before the Main DC switch. Obviously, in this situation, since the PVPs are kept shorted, they cannot feed the DC/DC converter(s) and the control circuitry: 42, 45 and 47, Fig. 4. Such switches controls are supplied just till the capacitor(s), 43, and ultracapacitor(s), 44, are still charged. Said time depends on capacitance value, system efficiency and energy consumption. But, if a right sequence is respected, and a correct activation frequency is chosen, there is virtually no limit to the period of time in which the string has zero volt or SELV (Safety Extra-Low Voltage) level at its output terminations. If we consider to let open just one switch of the whole string per time, and keep all the rest of the switches shorted, we will get at the output DC terminals always a voltage level lower than SELV (Safety Extra Low Voltage), which corresponds to the voltage of a single PVP.

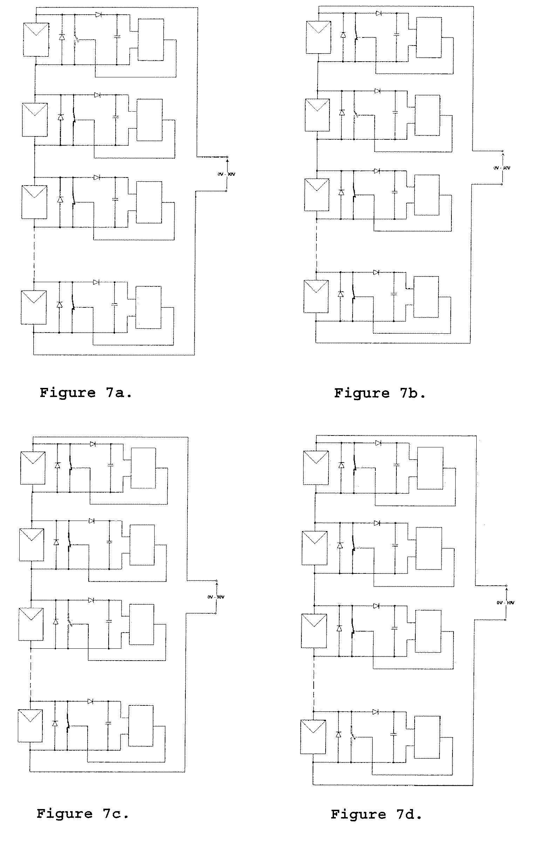

Typically, to discharge the capacitance and/or the Energy storage unit, 44, are necessary several minutes or even hours. If an activation period of few seconds or few minutes is chosen (i.e. from 5 to 10 times less than the discharging period), there is no need of any external feedback on the status of charge of the EDLC, 44, since the Storage Unit is discharged just of few volts. In case of increase of the activation frequency (up to few seconds or hundred milliseconds), it is preferably to have a bi-directional data transmission system to get a continuous monitoring of switches status. For instance, Figures 7a, 7b, 7c and 7d, detail this method of control. Practically, in Fig. 7a, from up to down, there's only the first switch which is open, whilst all the rest of switches of the string are kept shorted. At the DC Output terminals, it persists a SELV, corresponding to the output voltage of a single PVP. Fig. 7b is the second step of said control method, where the first switch will be closed and consequently the second switch will be opened assuring to pass, at the DC output terminations, from SELV to zero volt to SELV again. Fig. 7c shows a third step, in which there's only the third switch open and the rest of switches closed, assuring again to pass at the DC output terminations from SELV to zero volt to SELV again. Finally, Fig. 7d shows the last step of the control method (before it restarts from top again) where there's only the last switch open, whilst the rest of switches is closed.

Obviously, it does not matter the sequence, neither which switch is maintained open, but it is only important to keep just one (or, even, no-one) switch per time open. Of course, if a well defined sequence is repeated within a specific activation frequency, the capacitance value will result from an easy calculated. In general, for a correct design, it should be respected the following rule: the highest the activation frequency, the smaller the capacitance value. For instance, in multi-string or array solutions, where is preferable to keep a certain "dead-time" between two activation, the frequency will be chosen quite low and therefore the capacitors will be selected sufficiently large, and in some cases ultracapacitors, or supercapacitors, or hybrid capacitors and the like are necessary. In case of single string application (as in this specific example), instead, an high frequency of switches activations can be also tolerated and therefore it leads to a smaller capacitance value; therefore, in this case, standard electrolytic, tantalum or even foil/plastic capacitors can be also used.

## Claims

1. An Electronic system to be used as a Safety Switch at Photovoltaic Panel Level, comprising:
one, or more than one, main switch, 41, Fig. 4, in parallel to the Photovoltaic Panel (PVP), 11, and in parallel to the PVP by-pass diode(s), 48.
One, or more than one, blocking element(s), preferably diode(s), 49, Fig. 4.
A DC/DC converter, 42, necessary to charge, possibly at constant current, one (or more than one) capacitor(s), 43, and Energy Storage Unit(s), 44, at its output termination.
A Radio Frequency Activation System, capable to receive an activation signal and, eventually, to transmit feedback data, via Radio.
A control logic and driver circuitry, 47, capable to translate the received activation signal into right voltage and current level to be applied to the control terminals of the main switch, 41.
A transmitter electronics, 55, Figures 4 and 5, which is located in a nearby area, close to the PVPs. Once it is activated, by means of manual intervention pushing a safety button (i.e. in case of accident or
during installations or maintenance), or by means of intervention of electronic sensor board, 53 (fire detection, flooding detection, earthquakes, etc...) transmits the signal information and the activation codes with switches sequences to each PVP safety switch, 51. Said activation signals are **characterising in that,** with a defined frequency and activation sequences, allow to use ultra capacitors, supercapacitor, pseudo/hybrid capacitors and the like, or even - increasing the activation frequency - standard tantalum, electrolytic or plastic/foil capacitor, instead of electrochemical batteries.

2. An Electronic system, according to claim 1, wherein said main switch consist of one (or more than one) semiconductor device(s), such as BJT, IGBT, MOSFET, JFET and the likes.

3. An Electronic system, according to claim 1 and to claim 2, wherein said system is integrated into an external junction-box, 33, Fig. 3. Said junction-box in the existing PVP can be connected through standard cables, 15, and PVP connectors, 14. Said junction-box will be also provided with standard external PVP cables and connectors, 13 and 14, to allow electrical connection of PVPs in string, multi-string or array.

4. An Electronic system, according to claim 1 and to claim 2, wherein said system is integrated into a junction-box, 22, Fig. 2.

5. An Electronic system, according to claim 1 and to claim 2, wherein the internal DC/DC converter, 42, Fig. 4, it is not used and the capacitor(s), 43, and Energy storage unit(s), 44, are directly charged by the PVP through the blocking element(s), 49.

6. An Electronic system, according to claim 1, to claim 2 and to claim 5, wherein the Radio Frequency Activation System, 46, consists of a Wi-fi controlled system. Said system can be uni-directional or bi-directional in case of need of feedback on electronic switch status.

7. An Electronic system, according to claim 1, to claim 2 and to claim 5, wherein the Radio Frequency Activation System, 46, consists of a Bluetooth, Zigbee, or other systems and based on protected wireless protocols. Said system, can be uni-directional or bi-directional, in case of need of feedback on electronic switch status.

8. An Electronic system, according to claims 1, 2, 5, 6 and 7, wherein, in a PVP string, just one (or even, in some periods of time, no-one) switch per time is left open for a defined period of time. A well defined activation sequence is repeated within a specific activation frequency to give to the electronic system enough time to recharge the capacitor(s), 43, and the Energy Storage Unit(s), 44: the highest the activation frequency, the smaller the capacitance value.

9. An Electronic system, according to claims 1, 2, 5, 6, 7 and 8, wherein is provided a built-in over-voltage protection function to avoid over-voltages caused by non-contemporary activation of the main DC switch in paralleled multi-string PVP or PVP arrays, Fig. 8. Said system can also have wiring signal connection for redundant safety communication.
